(19) Europäisches Patentamt
European Patent Office
Office européen des brevets

(11) **EP 3 974 807 B1**

(12) **EUROPEAN PATENT SPECIFICATION**

(45) Date of publication and mention
of the grant of the patent:
**23.07.2025 Bulletin 2025/30**

(21) Application number: **21195051.4**

(22) Date of filing: **06.09.2021**

(51) International Patent Classification (IPC):
**G01N 21/00** (2006.01)     **G01N 23/00** (2006.01)
**G06T 7/60** (2017.01)     **G06F 30/27** (2020.01)

(52) Cooperative Patent Classification (CPC):
**G06T 7/60; G06F 30/27;** G01N 23/041;
G06T 2207/10116; G06T 2207/20081;
G06T 2207/20084

(54) **INFORMATION PROCESSING APPARATUS, LEARNING DEVICE, INFORMATION PROCESSING SYSTEM, INFORMATION PROCESSING METHOD, PROGRAM, AND NON-TRANSITORY STORAGE MEDIUM**

INFORMATIONSVERARBEITUNGSVORRICHTUNG, LERNVORRICHTUNG, INFORMATIONSVERARBEITUNGSSYSTEM, INFORMATIONSVERARBEITUNGSVERFAHREN, PROGRAMM UND NICHT-TRANSITORISCHES SPEICHERMEDIUM

APPAREIL DE TRAITEMENT D'INFORMATIONS, DISPOSITIF D'APPRENTISSAGE, SYSTÈME DE TRAITEMENT D'INFORMATIONS, PROCÉDÉ DE TRAITEMENT D'INFORMATIONS, PROGRAMME ET SUPPORT D'ENREGISTREMENT NON TRANSITOIRE

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **23.09.2020 JP 2020158289**

(43) Date of publication of application:
**30.03.2022 Bulletin 2022/13**

(73) Proprietor: **Konica Minolta, Inc.**
**Tokyo 100-7015 (JP)**

(72) Inventors:
• **OTA, Ikuma**
**Tokyo, 100-7015 (JP)**
• **EGUCHI, Yoshihiko**
**Tokyo, 100-7015 (JP)**

(74) Representative: **Gille Hrabal**
**Partnerschaftsgesellschaft mbB**
**Patentanwälte**
**Brucknerstraße 20**
**40593 Düsseldorf (DE)**

(56) References cited:
**EP-A1- 3 608 659        JP-A- 2002 273 772**
**JP-A- 2010 069 654**

• **ZHENGUO NIE ET AL: "Stress Field Prediction in Cantilevered Structures Using Convolutional Neural Networks", ARXIV.ORG, CORNELL UNIVERSITY LIBRARY, 201 OLIN LIBRARY CORNELL UNIVERSITY ITHACA, NY 14853, 27 August 2018 (2018-08-27), XP081368128**
• **HÜRKAMP ANDRÉ ET AL: "Integrated computational product and production engineering for multi-material lightweight structures", THE INTERNATIONAL JOURNAL OF ADVANCED MANUFACTURING TECHNOLOGY, SPRINGER, LONDON, vol. 110, no. 9-10, 11 September 2020 (2020-09-11), pages 2551 - 2571, XP037251657, ISSN: 0268-3768, [retrieved on 20200911], DOI: 10.1007/S00170-020-05895-6**

**Description**

BACKGROUND

Technical Field

The disclosure relates to an information processing apparatus, a learning device, an information processing system, an information processing method, program, and a non-transitory storage medium.

Related Art

Composites have been attracting attention in recent years. Members made from composite material have mechanical properties that are affected not only by the quality of material but by the fine internal structure of the material. For example, carbon-fiber-reinforced plastics (CFRPs) have a three-dimensional internal structure that depends on the way carbon fiber is weaved or oriented. The mechanical strength of a CFRP is significantly affected by the fiber orientation and fiber density.

Computer-aided-engineering (CAE) systems capable of evaluating the performance of a designed product and the like through simulation are widely used. To give an example, CAE systems are utilized for analyzing the strength of a structural component that has been designed, the strength of individual materials that are to be used, or the like. Using a CAE system can eliminate labor involved in carrying out field tests and can facilitate structural optimization and so on, reducing the development cost or development time or both.

Fiber-reinforced resin as a composite requires structural analysis that takes into consideration an orientation of the fiber. A conventional strength analysis method that shows high consistency with experimental values is available. In the conventional strength analysis method (see for example Japanese Patent No. 4574880, Patent Literature 1), coupled analysis involving the following steps is performed. First, simulations for flow analysis, pressure holding and cooling analysis, and fiber orientation analysis are carried out so that fiber orientation information (for example, a fiber orientation tensor) is obtained as an analytical result. Second, structural analysis that reflects the analytical result is carried out in a consolidated manner. However, depending on a combination of factors such as composite material, fiber material, a fiber length, and so on, there are cases where the conventional strength analysis method does not yield results that are consistent with experimental results.

EP3608659A1 discloses a quality inspection method in which an inner state of a three-dimensional laminated shaped product is inspected without destroying the product by using an X-ray Talbot imaging system. Talbot images are used to quantify the orientation state of fiber inside the three-dimensional laminated shaped product.

SUMMARY

Technical Problem

In order to improve the accuracy of strength analysis by the coupled analysis, a step (called validation) is necessary to verify whether the fiber orientation information, an intermediate product, obtained through the flow analysis agrees with an actual measurement. There are means to gain fiber orientation information of a real sample that covers the sample extensively. However, such means involve polishing the sample and observing the internal structure of the sample destructively using a scanning electron microscope (SEM), an optical microscope, or the like. Such a destructive observation has an effect on the sample surface that cannot be removed. Furthermore, in order to gain an understanding of the internal structure of the sample, a three-dimensional image reconstruction means such as computed tomography (CT) is necessary. However, because a large number of images need to be reconstructed, inspection takes time. Yet further, because the workpiece needs to be rotated, inspection of objects such as a large-sized component or large plate material is difficult to achieve. A method of inspecting composites that performs inspection in a short period of time that can be used to inspect large components is required. Validation requires cutting a sample into an adequate size for observation and making multiple observations to observe different parts of the sample. Validation therefore requires a significant amount of workload.

In view of the above, the object of the disclosure is to reduce the validation workload of sample analysis.

Solution to Problem

To achieve the abovementioned object, an information processing apparatus according to a first aspect of the disclosure is provided as defined in claim 1.

According to another aspect of the disclosure, an information processing apparatus is provided as defined in claim 3.

According to another aspect of the disclosure, an information processing method is provided as defined in claim 7.

According to another aspect of the disclosure, a program executable by a computer causes the computer to perform the information processing method according to the previous aspect.

According to another aspect of the disclosure, a non-transitory storage medium stores the program according to the previous aspect.

Advantageous Effects

According to the disclosure, the workload of validating sample analysis is reduced.

BRIEF DESCRIPTION OF DRAWINGS

The advantages and features provided by one or more embodiments of the disclosure will become more fully understood from the detailed description given hereinbelow and the appended drawings. The drawings are given for the purpose of illustration only and are not intended as a definition of the limits of the disclosure.

FIG. 1 is a schematic diagram of an information processing system according to one or more embodiments.

FIG. 2 is a flow chart of a process of a coupled analysis in accordance with a Comparative Example.

FIG. 3 is a flow chart of a process in accordance with a First Embodiment.

FIG. 4 is a schematic diagram of a sample.

FIG. 5 is a schematic diagram of a first Talbot image.

FIG. 6 is a schematic diagram of first Talbot orientation information.

FIG. 7 is a schematic diagram of a structural analysis model.

FIG. 8 is a graph showing a distribution of a two-dimensional scattering function.

DETAILED DESCRIPTION

Hereinafter, one or more embodiments of the disclosure will be described with reference to the drawings. However, the scope of the disclosure is not limited to the disclosed embodiments. The scope of the invention is defined by the appended claims.

In the following detailed description, for purposes of explanation, numerous specific details are set forth in order to provide a thorough understanding of the disclosed embodiments. It will be apparent, however, that one or more embodiments may be practiced without these specific details. In other instances, well-known structures and devices are schematically shown in order to simplify the drawing.

In the following detailed description, an "image" refers to image data unless there are exceptional circumstances.

First Embodiment

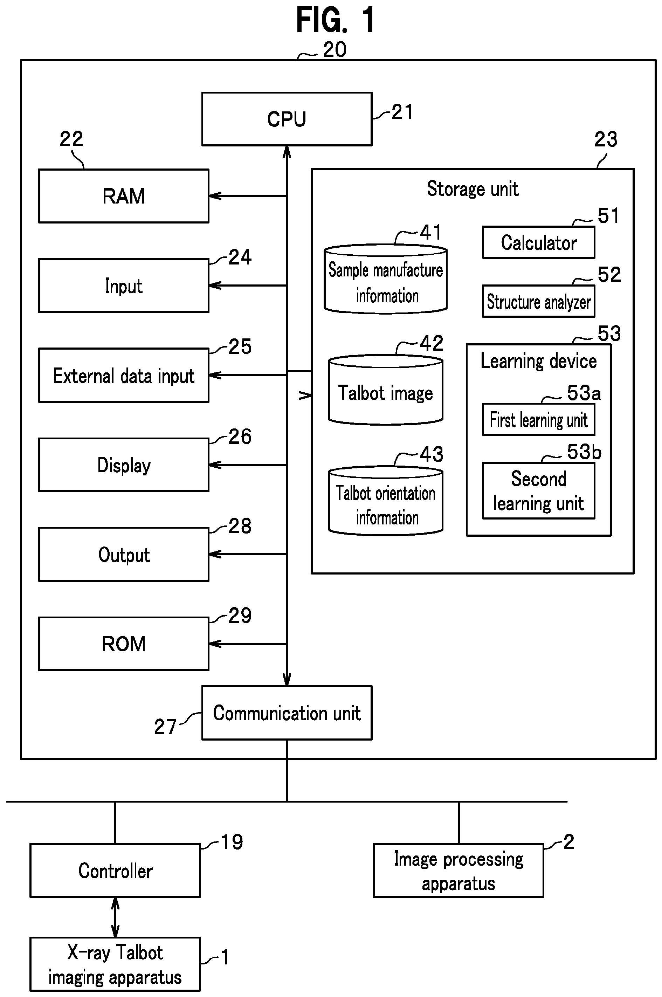

As shown in FIG. 1, an information processing system according to one or more of the present embodiment includes an X-ray Talbot imaging apparatus 1, a controller 19, an image processing apparatus 2, and a control apparatus 20. The X-ray Talbot imaging apparatus 1, the controller 19, the image processing apparatus 2, and the control apparatus 20 are communicably connected to each other via, for example, a bus.

The information processing system according to the present embodiment includes at least an X-ray Talbot imaging apparatus 1 and a control apparatus 20. An apparatus that is formed from a combination of the control apparatus 20 and image processing apparatus 2 is an example of an "information processing apparatus" of the disclosure. The control apparatus 20 can make up a part or a whole of the "information processing apparatus". X-Ray Talbot Imaging Apparatus

The X-ray Talbot imaging apparatus 1 uses a Talbot-Lau interferometer that includes a source grating (also referred to as a multi-grating, multi-slit, a G0 grating, or the like). In one or more embodiments, the X-ray Talbot imaging apparatus 1 uses a Talbot interferometer that includes a G1 grating and G2 grating but not a source grating. Since a configuration and function of the X-ray Talbot imaging apparatus 1 are disclosed, for example, in Reference Literature 1 (US Patent Application Publication No. US 2019/0317027 A1, publication date October 17, 2019), detailed description is omitted.

The X-ray Talbot imaging apparatus 1 can reconstruct at least three types of images (two-dimensional images) as reconstructed images by capturing a moire image of an object based on a principle of a fringe scanning method or by analyzing a moire image using a Fourier transform method. The reconstructed images are an absorption image, a differential phase image, and a small-angle scattering image.

An absorption image is an image rendered from an average component of moire fringes in a moire image and is the same as a normal X-ray absorption image.

A differential phase image is an image rendered from phase information of moire fringes.

A small-angle scattering image is an image rendered from visibility of moire fringes.

The X-ray Talbot imaging apparatus 1 can generate various types of images by recomposing an image using one or more of these three types of images.

The fringe scanning method obtains a high-definition reconstructed image by performing image reconstruction using moire images that have been captured M number of times. The moire images are captured by shifting one of multiple gratings by 1/M of a slit period of the grating in a direction of the slit period M number of times (M is a positive integer; M>2 for an absorption image; M>3 for a differential phase image or a small-angle scattering image).

The Fourier transform method involves capturing a single moire image in the presence of an object with the X-ray Talbot imaging apparatus 1. During image processing, a Fourier transform or the like is used to process the moire image to reconstruct and generate an image such as a differential phase image.

One example of an object whose image is captured by the X-ray Talbot imaging apparatus 1 is a composite (also referred to as a composite material). A composite material is a material in which two or more different materials are integrally combined and refers to a material in which at least two materials are present as phases. Materials such as alloys and ceramics made by mixing ingredients to form a single material are therefore not composite materials. Composite materials are used as constituent components of various products and so on such as spacecrafts, aircrafts, automobiles, ships, fishing rods, electric and electronic components, components in home appliances, parabolic antennae, bathtubs, floor materials, and roofing materials.

Known composite materials include fiber-reinforced plastics (FRPs), which use carbon fiber or glass fiber as reinforcing fiber, and ceramic matrix composites (CMCs), which use ceramic fiber as a reinforcing material. FRPs include carbon-fiber-reinforced plastics (CFRP), carbon-fiber reinforced-thermoplastics (CFRTPs), and glass-fiber reinforced plastics (GFRPs). More broadly, composites such as plywood that are made of a plurality of different types of wood may be included. Furthermore, composite materials such as metal matrix composites (MMC), concrete, and reinforced concrete that do not contain fiber may also be included.

Examples of resin used in composite materials include, but are not limited to, commodity plastic, engineering plastic, and super engineering plastic. Resin is used in the form of resin composite materials that have been added with a filler and are often used as molded plastic products. A filler used in resin composite materials has a micro- or nano-size structure and is added for the purpose of adding a predetermined property such as strength. Fillers include organic materials, inorganic materials, magnetic materials, and metallic materials. For example, when a molded plastic product needs to have strength or rigidity, a composite material made of resin such as polypropylene (PP), polyamide (PA), polyphenylene sulfide (PPS), or polyoxymethylene (POM) and a filler such as glass fiber (GF), aramid fiber, or mika may be used. For example, when a molded plastic material needs to be thin, a composite material made of liquid crystal polymer and GF is sometimes used. For example, when a molded plastic material is a plastic magnet, a composite material made of nylon resin and a filler such as strontium ferrite or samarium cobalt is often used.

<Controller>

The controller 19 performs overall control of the X-ray Talbot imaging apparatus 1. For example, the controller 19 may set the tube voltage, tube current, irradiation time, or the like of an X-ray source of the X-ray Talbot imaging apparatus 1. For example, the controller 19 may relay signals and data transmitted between an X-ray detector of the X-ray Talbot imaging apparatus 1 and the image processing apparatus 2 or another apparatus. The controller 19 functions as a control unit to capture a series of images for obtaining multiple moire images (a single moire image in the case of a Fourier transform method) that are used to generate a reconstructed image of an object.

<Control Apparatus>

The control apparatus 20 may for example be a general-purpose computer (a control PC) but is not limited to this. A part of the function of the control apparatus 20 may be provided over a network so that execution of individual processes involve data communication across the network when sending or receiving data.

As shown in FIG. 1, the control apparatus 20 includes a central processing unit 21 (a CPU 21), random-access memory 22 (RAM 22), a storage unit 23, an input 24, an external data input 25, a display 26, a communication part 27, and an output 28, read-only memory 29 (ROM 29). The input 24 and external data input 25 are examples of an "input" that one or more of the claims refer to.

The CPU 21 retrieves various types of programs such as a system program and processing program that are stored in the storage unit 23, places them into RAM 22, and executes various types of processes in accordance with the retrieved programs.

In various types of processes that are executed and controlled by the CPU 21, the RAM 22 functions as a work area for temporarily storing various types of programs that have been retrieved from the storage unit 23 and are executable by the CPU 21, input or output data, parameters, and so on.

The storage unit 23 is configured from a hard disk drive (an HDD), semiconductor non-volatile memory, or the like. In the storage unit 23, the various types of programs mentioned above and various types of data are stored.

The input 24 is configured to include a keyboard and a pointing device such as a mouse. The keyboard is equipped with keys including cursor keys, numeral input keys, and various function keys. The input 24 outputs a signal such as a signal generated from a key being pressed on the keyboard or a mouse operation signal to the CPU 21 as an input signal. The CPU 21 may execute various types of processes based on an operation signal from the input 24.

The external data input 25 is used to input data obtained from an externally provided device (including the controller 19) to the information processing system. One or more of a variety of data input means may be adopted as the external data input 25. Examples of a data input means are a Universal Serial Bus (USB) port capable sending and receiving data to and from an externally provided device over a wire or wirelessly, Bluetooth (a registered trademark), and a drive that reads data from a non-transitory storage medium corresponding to an externally provided device.

The display 26 is configured to include a monitor such as a cathode-ray tube monitor (a CRT monitor) or a liquid crystal display (an LCD). The display 26 displays various types of screens according to an instruction coming from a display signal inputted from the CPU 21. When the display 26 is a touch panel, the display 26 also includes a function of the input 24.

The communication unit 27 is equipped with a communication interface and communicates with an externally provided device in a network. The communication unit 27 may also be used the external data input 25 described above.

The output 28 outputs a result of a predetermined information processing. The predetermined information processing may for example be but is not limited to structural analysis of a structure analyzer 52 described later in the description. In cases where the outputted result is an image, the display 26 may be used to output the result.

The ROM 29 is a non-transitory storage medium for various types of programs stored in the storage unit 23. Instead of ROM 29, the non-transitory storage medium may be an above-mentioned non-transitory storage medium corresponding to an externally provided device.

<Image Processing Apparatus>

The image processing apparatus 2 performs image processing of output data from the X-ray Talbot imaging apparatus 1 and sends an image that has undergone image processing to the control apparatus 20. The display 26 may display the image received from the image processing apparatus 2.

The storage unit 23 stores, for example, sample manufacture information 41, a Talbot image 42, Talbot orientation information 43, a calculator 51, a structure analyzer 52, and a learning device 53 as shown in FIG. 1. Note that the image processing apparatus 2 functions as an image processing unit. The calculator 51, structure analyzer 52, and learning device 53 are, for example, implemented as a program, and functions when the program is read and executed by the CPU 21. The Talbot orientation information 43 is an example of the "orientation information" that one or more of the claims refer to.

The sample manufacture information 41 is information regarding a sample of a composite material that is an object to be imaged by the X-ray Talbot imaging apparatus 1. The sample manufacture information 41 includes a sample material, a molding condition, or both. Information regarding sample material may include but is not limited to a grade, condition of an additive, or both. Information regarding a molding condition of the sample may include but is not limited to a condition on temperature, condition on injection speed, and/or condition on holding pressure.

The Talbot image 42 is an image generated by a Talbot effect when imaging of a sample is performed with the X-ray Talbot imaging apparatus 1. An image obtained by the image processing apparatus 2 performing image processing on output data of the X-ray Talbot imaging apparatus 1 is also included as a Talbot image 42. The Talbot effect is a phenomenon in which X-rays emitted downwards from an X-ray source of the X-ray Talbot imaging apparatus 1 pass through a G1 grating and form self images (grating images) at regular distances in the vertical direction. Reconstructed images such as an absorption image, a differential phase image, and a small-angle scattering image that are reconstructed from a moire image are images generated by a Talbot effect and are therefore Talbot images 42. Note that the term "Talbot effect" not only refers to a Talbot effect by a Talbot interferometer but also refers to a combined effect of a Talbot effect and Lau effect (obtained with the use of a G0 grating) by a Talbot-Lau interferometer.

The Talbot orientation information 43 is orientation information that is obtained from a Talbot image 42. Note that orientation information is information that indicates an orientation of fiber of a sample.

The calculator 51 calculates Talbot orientation information 43 based on a Talbot image 42.

The structure analyzer 52 performs structural analysis of a sample based on Talbot orientation information 43. The output 28 may output a result of the structural analysis of the structure analyzer 52. The result of structural analysis may for example be, but is not limited to, at least one of tensile strength, stress distribution, or warpage of the sample.

The learning device 53 is a learning model for performing structural analysis of a sample with predetermined machine learning. The learning device 53 includes a first learning unit 53a and a second learning unit 53b. The first learning unit 53a and second learning unit 53b are examples of a "learning unit" that one or more of the claims refer to.

The first learning unit 53a is a learner that has undergone learning by associating sample manufacture information 41, which is to be an input, with a Talbot image 42, which is to be an output.

The second learning unit 53b is a learner that has undergone learning by associating sample manufacture information 41, which is to be an input, and Talbot orientation information 43, which is to be an output.

<Coupled Analysis of Comparative Example>

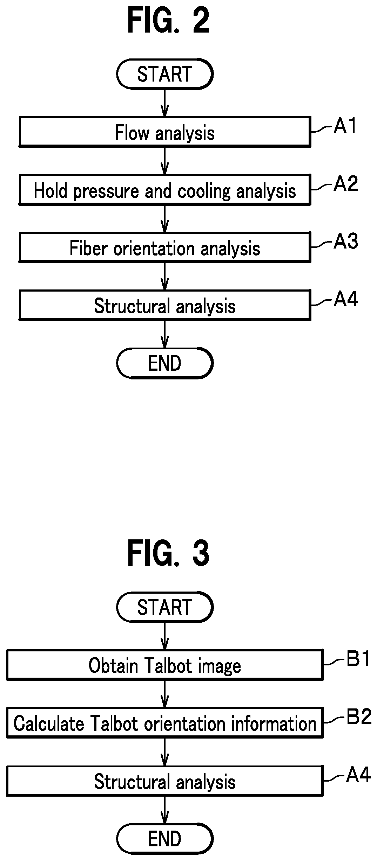

Coupled analysis of a Comparative Example will now be described with reference to FIG. 2. In the Comparative Example, a molded item that has been made from fiber reinforced resin (a composite material) through injection molding is used. Coupled analysis of the molded item performed with a CAE system proceeds as follows. The coupled analysis of the Comparative Example is, for example, described in Patent Literature 1 and follows the steps of Patent Literature 1.

First, a computer performs flow analysis using the following data to analyze flow of resin and fiber that are poured into a mold in injection molding (Step A1): data on the mold used in injection molding, data on the resin, and data on the fiber. Next, the computer performs pressure holding and cooling analysis using data on the molded item to analyze the pressure holding and cooling of the molded item (Step A2). Next, the computer performs fiber orientation analysis using data on a cooled molded item to analyze the fiber orientation of the cooled molded item (Step A3).

Finally, the computer performs structural analysis using a result of the fiber orientation analysis as input information (Step A4). The computer performs the analysis by mapping the fiber orientation information (the result of the fiber orientation analysis) onto a structural analysis model that includes shape data that is the same as the molded item. As a result of the structural analysis, a result of strength analysis such as tensile strength, stress distribution, or warpage of the molded item is obtained.

The coupled analysis of the Comparative Example is a series of analyses that takes into consideration interaction between multiple fields (such as fluid and structure). However, the coupled analysis of the Comparative Example requires validation of the fiber orientation information to improve the accuracy of the result of strength analysis that adds a significant amount of labor and burden. Actual measurements of fiber orientation information that are necessary for the validation of fiber orientation information are obtained by performing orientation information analysis using an optical microscope, an SEM, or a microfocus CT.

Orientation information analysis using an optical microscope or SEM involves observing a surface state of an observed portion of a sample in a way that causes damage to the sample. Due to the destructiveness of this observation technique, it is difficult to exclude the effect of the observation on the sample surface.

The microfocus CT is a technology that performs magnified imaging using X-ray CT. Orientation information analysis using microfocus CT is a method whereby a difference in the X-ray absorption of a filler is visualized in a three-dimensional manner by using a voxel size that is less than or equal to the size of a filler structure (e.g., a few micro-meters). In cases where the difference in X-ray absorption between resin and the filler (sensitizer) is small (e.g., in the case of CFRPs), it is difficult to obtain a contrast and thus difficult to make an observation with this method. Furthermore, because magnified imaging is involved, the shooting range of a sample that is commonly used is a few millimeter (mm) squared. To gain overall orientation information of a sample whose size is greater than 10 mm, images must be captured multiple times, requiring time and effort.

<Process>

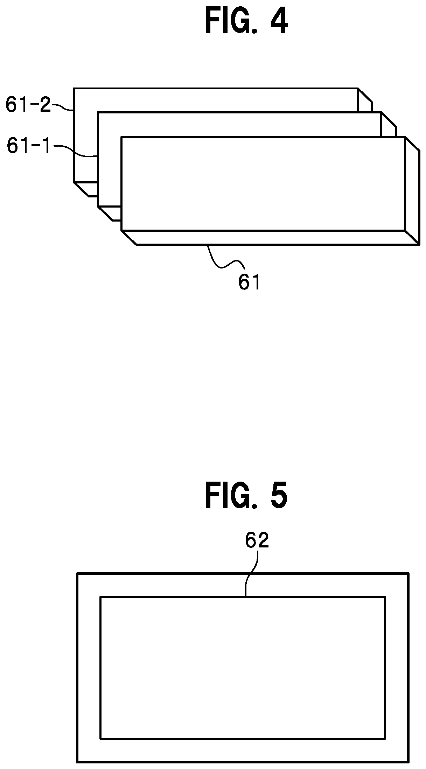

A process of the present embodiment is described with reference to FIG. 3 (and to other figures as deemed appropriate). The process for a molded item made by injection molding fiber-reinforced resin (a composite material) follows the steps given below. It should be noted that imaging of a sample, which is a molded item, using the X-ray Talbot imaging apparatus 1 has taken place prior to step B1. FIG. 4 shows a schematic diagram of three samples. Samples 61, 61-1, and 61-2 are molded items that have the same shape but have each been made using a different composite material, molding condition, or the like. The process of FIG. 3 may be carried out for each of the samples 61, 61-1, and 61-2. The process of FIG.3 is described below using a case where sample 61 is used.

In Step B1, the control apparatus 20 obtains a Talbot image 42 from either the X-ray Talbot imaging apparatus 1 or image processing apparatus 2. FIG. 5 shows a schematic diagram of a first Talbot image 62 (a specific example of a Talbot image 42) of sample 61. Although in FIG. 5 the first Talbot image 62 is shown two-dimensionally, a three-dimensional Talbot image may be captured.

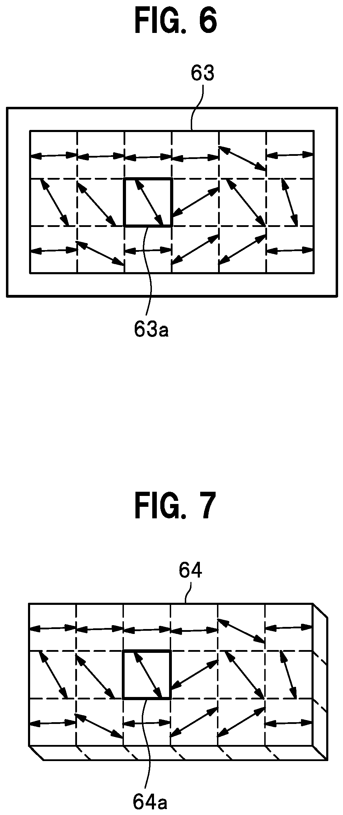

Next, in Step B2, the calculator 51 of the control apparatus 20 calculates Talbot orientation information 43 based on the Talbot image 42. FIG. 6 shows a schematic diagram of first Talbot orientation information 63 (a specific example of Talbot orientation information 43) of the sample 61. As shown in FIG. 6, the first Talbot orientation information 63 uses a mesh to divide a predetermined region into mesh elements and indicates a main orientation component of fiber for each mesh element with a double arrow (details given later). A dimension of a mesh element may range between (i) a minimum dividing unit approximately between several tens of micrometers to a hundred and several tens of micrometers as determined by a pixel size and (ii) approximately several millimeters corresponding to a plurality of the pixel size. Note that the Talbot orientation information 43 is equivalent, or an appropriate design change is made to become equivalent, to the fiber orientation information resulting from fiber orientation analysis of the coupled analysis of the Comparative Example. In cases where the first Talbot image 62 is two-dimensional, the first Talbot orientation information 63 is also two-dimensional.

Finally, in Step A4, the structure analyzer 52 of the control apparatus 20 performs the structural analysis that has been described above using the Talbot orientation information 43 as input information. FIG. 7 shows a schematic diagram of a first structural analysis model 64 (a specific example of the structural analysis model). The first structural analysis model 64 is a model in which a predetermined region has been divided with a mesh so that a mapping with the first Talbot orientation information 63 is possible. The first structural analysis model 64 is configurable using known art. The structure analyzer 52 maps the Talbot orientation information 43 on to a structural analysis model that has the same shape data as the molded item (for example, orientation information 63a of a mesh element of FIG. 6 is reflected in a corresponding mesh element 64a of FIG. 7) and performs analysis. As a result of the structural analysis, a result of strength analysis such as tensile strength, stress distribution, or warping of the molded item may be obtained.

The first structural analysis model 64 is a three-dimensional model. By assuming that a fiber direction is uniform across a direction of thickness when inputting two-dimensional first Talbot orientation information 63 to the first structural analysis model 64, structural analysis becomes possible. When a three-dimensional Talbot image and three-dimensional Talbot orientation information are inputted to the first structural analysis model 64, the abovementioned assumption is unnecessary.

The display 26 can display the first Talbot image 62, first Talbot orientation information 63, first structural analysis model 64, and result of structural analysis.

<Details of Imaging by X-ray Talbot Imaging Apparatus 1>

Imaging of a sample with the X-ray Talbot imaging apparatus 1 involves orientation imaging. Orientation imaging refers to imaging in which the relative angle between the gratings and a sample (an object that is imaged; a molded item) is changed by rotating an object-placing stage of the X-ray Talbot imaging apparatus 1 that functions as a rotating stage. Through orientation imaging, a direction in which a signal value becomes strongest for each pixel may be determined with arithmetic processing.

<Details of Talbot Orientation Information 43>

The Talbot orientation information 43 that is calculated by the calculator 51 based on a Talbot image 42 is described in detail (Steps B1 and B2 of FIG. 3).

Beforehand, during orientation imaging with the X-ray Talbot imaging apparatus 1, imaging of the sample is carried out using different relative angles between the sample and the gratings. At least three different relative angles are used (e.g., 0°, 60°, and 120°; selected relative angles). Each of the selected relative angles may be achieved, for example, by rotating the sample while keeping the apparatus side fixed or by rotating the apparatus side while keeping the sample fixed. The following description uses two-dimensional imaging as an example but may be extended to three-dimensional imaging as well.

Next, a Talbot image is obtained at each of the selected relative angles. Here, at least one of the absorption image, differential phase image, or small-angle scattering image may be obtained. In the following description, a small-angle scattering image or a small-angle scattering image divided by an absorption image is used. A small-angle scattering image divided by an absorption image may be viewed as an image whose thickness dependence has been cancelled in cases where a sample has an uneven surface. For convenience of explanation, a small-angle scattering image and a small-angle scattering image divided by an absorption image are collectively referred to as a "small-angle scattering image".

Next, the small-angle scattering images (at least three) that have been obtained at the selected relative angles are aligned. Here, because the sample has been rotated, an operation to return the images to a predetermined angle is performed.

Next, for each pixel, fitting is performed with a sine wave and a fitting parameter is extracted. The graph of the sine wave has an x-axis that represents a relative angle between the sample and the gratings and a y-axis that represents a small-angle scattering signal value of a pixel. The amplitude, average value, and phase of the sine wave are obtained as fitting parameters. An image showing amplitude values of individual pixels is referred to as an "amp image". An image showing average values of individual pixels is referred to as an "ave image". An image showing phases of individual pixels is referred to as a "pha image". The amp image, ave image, and pha image are collectively referred to as an "orientation image".

Finally, an averaging process is performed in 1 mm squared regions of the pha image to obtain main orientation information.

An orientation image depicts orientations of resin and fiber of a material of a molded item. The main orientation information is information showing a collection of main orientation components of the fiber for individual regions (corresponding to mesh elements) of a predetermined mesh of the pha image. For example, the calculator 51 may use the main orientation information as Talbot orientation information 43 so that the main orientation information is used as input information for a structural analysis model described in a later paragraph.

<Alternative Representation of Talbot Orientation Information 43 (First Example)>

As mentioned above, the main orientation information may be used as input information for a structural analysis model. However, when a structural analysis model allows an orientation tensor to be used as input information, the calculator 51 may convert a Talbot image 42 to an orientation tensor. In other words, an orientation tensor may be used to represent Talbot orientation information 43.

For example, a two-dimensional orientation p of the fiber for each pixel may be described by the following expression. Angle $\theta$ represents an angle from the x-axis.

[Formula 1]

$$\mathbf{p} = \begin{pmatrix} \cos\theta \\ \sin\theta \end{pmatrix}$$

$$\ldots\ldots \text{Equation 1}$$

When n number of two-dimensional orientations exist in a region, the average state of orientations in that region may be defined using a two-dimensional orientation tensor A as shown below in Equation 2.

[Formula 2]

$$\mathbf{A} = \begin{pmatrix} \langle p_1 p_1 \rangle & \langle p_1 p_2 \rangle \\ \langle p_2 p_1 \rangle & \langle p_2 p_2 \rangle \end{pmatrix} = \begin{pmatrix} \frac{1}{n}\sum p_1 p_1 & \frac{1}{n}\sum p_1 p_2 \\ \frac{1}{n}\sum p_1 p_2 & \frac{1}{n}\sum p_2 p_2 \end{pmatrix}$$

$$\ldots \text{Equation 2}$$

Here, the sum of diagonal components of the two-dimensional orientation tensor is 1 (trace A = 1). Also, $p_1$ and $p_2$ of Equation 2 are values of p when $\theta$ of Equation 1 takes different values.

For example, the calculator 51 may use the orientation tensor as Talbot orientation information 43 so that the orientation tensor is used as input information for the structural analysis model described in a later paragraph.

<Alternative Representation of Talbot Orientation Information 43 (Second Example)>

The above-mentioned main orientation information may be used as input information for a structural analysis model. However, when a structural analysis model allows a tensor representation of a two-dimensional scattering function to be used as input information, the calculator 51 may convert a Talbot image 42 into a tensor representation of a two-dimensional scattering function. In other words, the tensor representation of a two-dimensional scattering function may be used to represent Talbot orientation information 43. The explanation of this follows Reference Literature 2 (Directional x-ray dark-field imaging of strongly ordered systems, PHYSICAL REVIEW B 82, 214103 [2010]).

According to Reference Literature 2, when a two-dimensional scattering function $\mu(x, y)$ of a scatterer spread across between the x- and y-axes is considered using a Gaussian function model, the two-dimensional scattering function may be described using Equation 3 given below.

[Formula 3]

$$\mu(x, y) = \frac{1}{2\pi\sigma_1\sigma_2} \exp\left(-(ax^2 + bxy + cy^2))\right)$$

$$a = \frac{\cos^2\theta_0}{2\sigma_1^2} + \frac{\sin^2\theta_0}{2\sigma_2^2}$$

$$b = \sin\theta_0 \cos\theta_0 \left(-\frac{1}{2\sigma_1^2} + \frac{1}{2\sigma_2^2}\right)$$

$$c = \frac{\sin^2\theta_0}{2\sigma_1^2} + \frac{\cos^2\theta_0}{2\sigma_2^2}$$

$$\ldots\ldots \text{Equation 3}$$

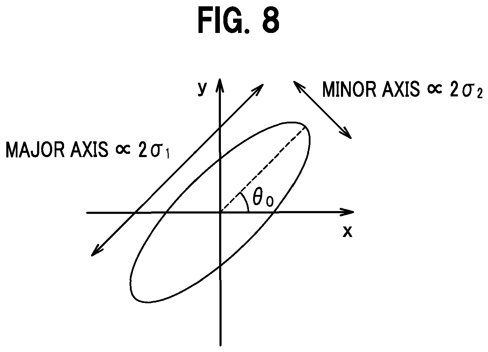

Here, ($\sigma_1$ and $\sigma_2$ are indices indicating the anisotropy of scattering in magnitude-specific directions of principal-axis components of a Gaussian function. For a scatterer such as fiber, the values of $\sigma_1$ and $\sigma_2$ become large. For this reason, a ratio of $\sigma_1$ and $\sigma_2$ may be used as an index of anisotropy. As shown in FIG. 8, the ratio of a major axis and a minor axis when a contour of a scatter function is drawn is $2\sigma_1 : 2\sigma_2$, and this ratio can be used as an index of anisotropy. Furthermore, $\theta_0$, as indicated in FIG. 8, is the angle between $\sigma_1$ and the x axis. For example, when the distribution of fiber orientations spread across an x-y space shows that many of the individual fibers are inclined at angle of 45 degrees with respect to the x-axis, then $\theta_0 = 45$.

Equation 4 below shows a tensor representation U of the scattering function with a, b, and c representing components of the tensor.

[Formula 4]

$$\mathbf{U} = \begin{pmatrix} a & b \\ b & c \end{pmatrix}$$

$$\ldots\ldots \text{Equation 4}$$

The small-angle scattering image obtained from Talbot image capturing may be expressed in terms of $\theta$, a relative angle between the gratings and a scatterer, as shown in Equation 5 below. k is a constant determined by the grating period.

[Formula 5]

$$V(\theta) = \exp(-k(\sigma_1^2 + \sigma_2^2)) \exp(-k(\sigma_1^2 - \sigma_2^2) \cos(2(\theta - \theta_0) - \pi)$$

$$\ldots\ldots \text{Equation 5}$$

By applying logarithmic transformation and adding a negative sign to Equation 5 (so that the equation becomes more interpretable), Equation 6 is obtained.

[Formula 6]

$$SC(\theta) = -\ln V(\theta) = k(\sigma_1^2 + \sigma_2^2) - k(\sigma_1^2 - \sigma_2^2) \cos(2(\theta - \theta_0))$$

$$\ldots\ldots \text{Equation 6}$$

By capturing an image of a sample multiple times during the Talbot image capturing process using different relative angles between the sample and gratings, it becomes possible to calculate a maximum value (max) of SC(θ), a minimum value (min) of SC(θ), and an angle $\theta_0$ when SC(θ) is the largest (see Equation 7). (This is similar to the procedure for extracting an orientation image described above.)

[Formula 7]

$$max = SC(\theta_0) = 2k\sigma_2^2$$

$$min = SC(\theta_0 + \frac{1}{2}\pi) = 2k\sigma_1^2$$

. . . . . Equation 7

Next, by applying the information obtained from Talbot image capturing to the tensor representation U of a two-dimensional scattering function, Equation 8 is obtained.

[Formula 8]

$$\mathbf{U} = k \begin{pmatrix} \frac{\cos^2 \theta_0}{max} + \frac{\sin^2 \theta_0}{min} & \sin \theta_0 \cos \theta_0 \left( -\frac{1}{max} + \frac{1}{min} \right) \\ \sin \theta_0 \cos \theta_0 \left( -\frac{1}{max} + \frac{1}{min} \right) & \frac{\sin^2 \theta_0}{max} + \frac{\cos^2 \theta_0}{min} \end{pmatrix}$$

. . . . . Equation 8

The two-dimensional scattering function expresses a spatial distribution of a scattering image. Therefore, the two-dimensional scattering function is considered to correspond to an orientation tensor of fiber orientation analysis. Here, the sum of diagonal components of the orientation tensor of fiber orientation analysis is defined as one. Normalizing the tensor representation U of the two-dimensional scattering function by the diagonal components results in $U_{norm}$ as defined by Equation 9.

[Formula 9]

$$\mathbf{U_{norm}} = k_{norm} \begin{pmatrix} \frac{\cos^2 \theta_0}{min} + \frac{\sin^2 \theta_0}{max} & \sin \theta_0 \cos \theta_0 \left( -\frac{1}{min} + \frac{1}{max} \right) \\ \sin \theta_0 \cos \theta_0 \left( -\frac{1}{min} + \frac{1}{max} \right) & \frac{\sin^2 \theta_0}{min} + \frac{\cos^2 \theta_0}{max} \end{pmatrix}$$

$$k_{norm} = \frac{k}{min} + \frac{k}{max}$$

. . . . . Equation 9

For example, the calculator 51 may use the tensor representation U of the two-dimensional scattering function as Talbot orientation information 43 so that the tensor representation U is used as input information for the structural analysis model described in a later paragraph.

<Details of Structural Analysis Using Talbot Orientation Information 43>

In the structural analysis described above, the structural analysis model is prepared by using a mesh to split the shape of an object under analysis into mesh elements and inputting physical property information for each mesh element (see FIG. 7). When the object under analysis is a composite, the following are input as physical property information for individual mesh elements: a physical property of resin used as base material, a physical property of fiber, and orientation information of fiber.

For example, the physical property of resin and physical property of fiber may be data of a tensile stress - strain curve. Data of the tensile stress - strain curve can be referenced from a database of a predetermined simulation.

The orientation information of fiber may be Talbot orientation information 43.

Structural analysis such as this is a known technique and can be implemented by using software such as Digimat (a product of e-Xstream engineering) and PlanetsX (a product of Ansys).

Note that the structural analysis of the present embodiment assumes that unevenness in the concentrations of resin and fiber does not exist. Therefore, values of resin and fiber concentrations that are inputted for individual mesh elements of the structural analysis model are kept the same. By using this condition, calculation load of structural analysis is reduced.

In one or more embodiments, differences in resin and fiber concentrations are considered, in which case different values of resin and fiber concentrations are inputted for individual mesh elements of the structural analysis model. This may be achieved, for example, by converting signal strength information of an absorption image of a Talbot image into degrees of concentration of the resin and by converting signal strength information of an ave image of an orientation image into degrees of concentration of the fiber.

In the structural analysis of the present embodiment, it is assumed that the resin and fiber do not shrink. Therefore, values of shrinkage strain of the fiber that are inputted for individual mesh elements of the structural analysis model are kept the same. By using this condition, calculation load of structural analysis is reduced.

In one or more embodiments, shrinkage of the resin and fiber are considered, and values of shrinkage strain of the resin and fiber that are inputted for individual mesh elements of the structural analysis model are set individually.

In one or more embodiments, with regards to the values of shrinkage strain and concentrations of resin and fiber, flow analysis and hold pressure and cooling analysis are implemented so that values obtained therefrom are used as inputted values.

<Details of Result of Structural Analysis>

By applying loading data such as boundary condition data, external force, or imposed displacement as input data to a structural analysis model, response data (regarding response to the loading) such as amount of deformation data or stress data is obtained as output data. Response data is an example of a result of strength analysis. Structural analysis such as this is a known technique and can be implemented by using software such as Digimat (a product of e-Xstream engineering) and PlanetsX (a product of Ansys).

<Advantageous Effects of First Embodiment>

In the coupled analysis of the Comparative Example, the fiber orientation information resulting from the fiber orientation analysis is fictitious data obtained from simulation. In contrast, a Talbot image 42 that is generated through imaging by the X-ray Talbot imaging apparatus 1 and through image processing by the image processing apparatus 2 is measured data. Therefore, Talbot orientation information 43 calculated from the Talbot image 42 is also measured data. Therefore, according to the process of FIG. 3, since the input information for the structural analysis is measured data, validation of fiber orientation information used as input information for the structural analysis is unnecessary. As a result, workload for validating analysis of a sample can be reduced.

Furthermore, because the diameter of a fiber is in the range between several $\mu$m and several tens of $\mu$m, fiber orientation analysis of a composite material not only requires a field of view that covers the entire sample whose size may be over 10 mm but requires resolution in the order of micrometers as well.

With conventional devices such as an optical microscope, an SEM, and a microfocus CT, not only is it necessary to make an observation of a magnified projection of the sample (in order to achieve resolution in the order to micrometers), but observation needs to be performed multiple times to observe different parts of the sample (in order to analyze the fiber orientation of the entire sample). In contrast, a Talbot image 42 is by principle able to obtain, in a region of approximately several tens of $\mu$m to a hundred and several tens of $\mu$m that is determined by pixel size, a signal that is proportional to the amount of fiber that is parallel to a grating orientation (a direction in which individual slits of the gratings extend). Therefore, fiber orientations over a region that is more than ten times as large compared to conventional devices can be captured. Because of this, image taking with the X-ray Talbot imaging apparatus 1 generally takes place once (although images must be captured at least three times using different relative angles between the sample and gratings, this is different to capturing images of different parts of the sample). Because an analyzed area of composite material using the X-ray Talbot imaging apparatus 1 is larger than the analyzed area using conventional devices, labor involved in sample observation can be reduced.

Second Embodiment

The following description of a Second Embodiment omits parts that overlap with the description of the First Embodiment and focuses on the differences. With regards to the parts that overlap with the First Embodiment, the issue that can be overcome with the First Embodiment can also be overcome with the Second Embodiment. Furthermore, with regards to the parts that overlap with the First Embodiment, the advantageous effects of the First Embodiment are also achieved with the Second Embodiment.

The first learning unit 53a is used in the Second Embodiment. The first learning unit 53a comprises a surrogate model. A surrogate model, an alternative to mathematical simulation, predicts a phenomenon using machine learning and is known art. Machine learning is, for example, a neural network, but is not limited to this. Surrogate models predict a phenomenon faster than mathematical simulation and its usage includes shape optimization and conceptual design.

A learning phase of the first learning unit 53a proceeds as follows. First, a set of samples is fabricated using the same mold. Each sample (of the set) is fabricated with a different material or molding condition or both. The used material and molding condition are stored as sample manufacture information 41 in the storage unit 23 and are also used as input data x0 for the first learning unit 53a. Note that inputting information to the first learning unit 53a is carried out by at least one of the input 24 or external data input 25.

Next, imaging of the fabricated samples are carried out with the X-ray Talbot imaging apparatus 1 and Talbot images 42 are generated. The Talbot images 42 are stored in the storage unit 23 and are also used as output data (teaching data) y0 for the first learning unit 53a. Finally, a learning model that has learned a function y0 = F(x0) is generated that is used as the first learning unit 53a. F is a predetermined function used in the surrogate model and is a design factor.

A prediction phase of the first learning unit 53a proceeds as follows. It is assumed that the mold of a molded item is the same as the mold used in the learning phase. The shape of the molded item is therefore the same as the set of samples. First, a material and molding condition that have been selected for the molded item are inputted to the first learning unit 53a. Next, the first learning unit 53a predicts and generates a Talbot image.

With the above, the prediction phase is complete. After the prediction phase, the calculator 51 calculates Talbot orientation information 43 based on the predicted Talbot image. Furthermore, based on the calculated Talbot orientation information 43, the structure analyzer 52 performs structural analysis of a sample (data) corresponding to the material and molding condition that have been inputted. The output 28 outputs a result of the structural analysis performed by the structure analyzer 52.

According to the present embodiment, part of a preparatory process prior to the structural analysis is achieved using machine learning, and therefore, labor involved in obtaining a result from structural analysis can be reduced.

Third Embodiment

The following description of a Third Embodiment omits one or more parts that overlap with the description of the First and Second Embodiments and focuses on the differences. With regards to the parts that overlap with the First Embodiment and/or Second Embodiment, the issue that can be overcome with the First Embodiment and/or Second Embodiment can also be overcome with the Third Embodiment. Furthermore, with regards to the parts that overlap with the First Embodiment and/or Second Embodiment, the advantageous effect of the First Embodiment and/or Second Embodiment are also achieved with the Third Embodiment.

The second learning unit 53b is used in the Third Embodiment. The second learning unit 53b comprises a surrogate model. Machine learning used for the surrogate model is, for example, a neural network, but is not limited to this.

A learning phase of the second learning unit 53b proceeds as follows. First, a set of samples is fabricated using the same mold. Each sample (of the set) is fabricated with a different material or molding condition or both. The used material and molding condition are stored as sample manufacture information 41 in the storage unit 23 and are also used as input data x0 for the second learning unit 53b. Note that inputting information to the second learning unit 53b is carried out by at least one of the input 24 or external data input 25.

Next, imaging of the fabricated samples are carried out with the X-ray Talbot imaging apparatus 1 and Talbot images 42 are generated. The Talbot images 42 are stored in the storage unit 23. Next, the calculator 51 calculates Talbot orientation information 43 based on the generated Talbot images 42. The calculated Talbot orientation information 43 is stored in the storage unit 23 and is also used as output data (teaching data) y1 for the second learning unit 53b. Finally, a learning model that has learned a function y1 = G(x0) is generated that is used as the second learning unit 53b. G is a predetermined function used in the surrogate model and is a design factor.

A prediction phase of the second learning unit 53b proceeds as follows. It is assumed that the mold of a molded item is the same as the mold that was used in the learning phase. The shape of the molded item is therefore the same as the set of samples. First, material and a molding condition that are selected for the molded item are inputted to the second learning unit 53b. Next, the second learning unit 53b predicts and generates Talbot orientation information. In the Third Embodiment, the calculator 51 may be used in the prediction function of the second learning unit 53b.

With the above, the prediction phase is complete. After the prediction phase, the structure analyzer 52 performs, based on the predicted Talbot orientation information, structural analysis of a sample (data) corresponding to the material and molding condition that have been inputted. The output 28 outputs a result of the structural analysis performed by the structure analyzer 52.

According to the present embodiment, part of a preparatory process prior to the structural analysis is achieved using machine learning, and therefore, labor involved in obtaining a result from structural analysis can be reduced. Especially, because a Talbot image is not necessary in the prediction phase, imaging with an X-ray Talbot imaging apparatus 1 is unnecessary, reducing labor even further.

Variations

(a) Although the above embodiments have been described for a molded item made from injection molding, the disclosure is applicable to molded items made from press molding.

(b) Learning units are not limited to the first learning unit 53a and second learning unit 53b. Input data and output data that are associated with each other using machine learning may be altered as deemed appropriate. For example, in one or more embodiments not according to the claimed invention,

a learning unit may be created whose input data is sample manufacture information 41 and output data is a result of structural analysis of the structure analyzer 52. For example, in one or more embodiments not according to the claimed invention,

a learning unit may be created whose input data is a Talbot image 42 and output data is Talbot orientation information 43. For example, in one or more embodiments not according to the claimed invention,

a learning unit may be created whose input data is a Talbot image 42 and output data is a result of structural analysis of the structure analyzer 52. For example, in one or more embodiments not according to the claimed invention,

a learning unit may be created whose input data is Talbot orientation information 43 and output data is a result of structural analysis of the structure analyzer 52.

(c) Various techniques of the disclosure that have been described may be combined as deemed appropriate.

Although embodiments of the disclosure have been described and illustrated in detail, the disclosed embodiments are made for purposes of illustration and example only and not limitation. Modifications and variations of the embodiments described above will occur to those skilled in the art in light of the above teachings. The scope of the disclosure should be interpreted by terms of the appended claims.

**Claims**

1. An information processing apparatus comprising:

   an input (24, 25) configured to input sample manufacture information (41) of a composite material sample;
   **characterized by**
   a learning unit (53a, 53b) comprising a surrogate model and configured to predict a Talbot image in a prediction phase based on the sample manufacture information (41) of the composite material sample,, the sample manufacturing information including at least one of a sample material and a molding condition, after having undergone learning in a learning phase by associating the sample manufacture information (41) of samples, with Talbot images; and
   a calculator (51) configured to calculate orientation information (43) of the sample based on the predicted Talbot image, wherein orientation information (43) is information that indicates an orientation of fiber of the composite material sample; wherein
   the learning unit (53a) is configured to in the learning phase:

      obtainesample manufacture information (41) of a set of samples;
      obtain Talbot images (42) obtained by imaging the samples with an X-ray Talbot imaging apparatus (1); and
      learn by associating the sample manufacture information (41) of the samples with the Talbot images (42) such that the learning unit (53a) with the surrogate model can predict a Talbot image in the prediction phase based on the sample manufacture information (41) of the sample.

2. The information processing apparatus according to claim 1 further comprising:

a structure analyzer (52) configured to perform structural analysis of the sample based on the calculated orientation information (43); and

an output (28) configured to output a result of the structural analysis.

3. An information processing apparatus comprising:

an input (24, 25) configured to input sample manufacture information (41) of a composite material sample;
**characterized by**
a learning unit (53a, 53b) comprising a surrogate model and configured to predict in a prediction phase orientation information (43) of the sample based on manufacture information (41) of the sample after the learning unit (53a, 53b) has undergone learning in a learning phase by associating the sample manufacture information (41) of composite material samples,, the sample manufacture information including at least one of a sample material and a molding condition, with a set of orientation information (43) obtained based on Talbot images, wherein orientation information (43) is information that indicates an orientation of fiber of the composite material sample; and

the learning unit (53b) is configured to:

obtain the sample manufacture information (41) of a set of samples;
obtain Talbot images (42) obtained by imaging the samples with an X-ray Talbot imaging apparatus (1);
obtain orientation information (43) based on the Talbot images (42) by using a calculator (51); and
learn by associating the sample manufacture information (41) of the samples with the orientation information (43) such that the learning unit (53b) with the surrogate model can predict an orientation information (43) in the prediction phase based on the sample manufacture information (41) of the sample.

4. The information processing apparatus according to claim 3 further comprising:

a structure analyzer (52) configured to perform structural analysis of the sample based on the predicted orientation information (43); and
an output (28) configured to output a result of the structural analysis by the structure analyzer (52).

5. The information processing apparatus according to claim 1, comprising:

a structure analyzer (52) configured to perform structural analysis of a sample based on orientation information (43) obtained based on the Talbot image of the sample; and
an output (28) configured to output a result of the structural analysis by the structure analyzer (52).

6. An information processing system comprising:

the information processing apparatus according to claim 5 including the structure analyzer (52) and the output (28),
and a display (26); and
an X-ray Talbot imaging apparatus (1), wherein
the information processing apparatus is configured to:

obtain a Talbot image by imaging a sample with the X-ray Talbot imaging apparatus;
obtain orientation information of the sample based on the Talbot image;
perform, with the structure analyzer (52), structural analysis of the sample based on orientation information of the sample;
output, with the output (28), a result of the structural analysis; and
display, with the display (26), the Talbot image, the orientation information, a structural analysis model (64) used in the structural analysis, and the result of the structural analysis.

7. An information processing method of an information processing apparatus, the information processing method comprising:

predicting, by a learning unit (53a, 53b) with a surrogate model in a prediction phase, orientation information (43) of a composite material sample after having undergone learning in a learning phase by associating sample manufacture information (41) of composite material samples,the sample manufacture information (41) including at least one of a sample material and a molding condition, with a set of orientation information obtained based on Talbot images of the samples, wherein orientation information (43) is information that indicates an orientation of fiber of the composite material sample;

performing structural analysis of the sample based on the predicted orientation information; and

outputting a result of the structural analysis.

8.  A program executable by a computer, the program causing the computer to perform the information processing method according to the preceding claim.

9.  A non-transitory storage medium storing the program according to the preceding claim.

**Patentansprüche**

1.  Ein Informationsverarbeitungsgerät umfassend:

    Einen Eingang (24, 25), der dazu eingerichtet ist, Probenherstellungsinformationen (41) einer Verbundwerkstoffprobe einzugeben;
    **gekennzeichnet durch**
    eine Lerneinheit (53a, 53b), die ein Ersatzmodell umfasst und dazu eingerichtet ist, ein Talbot-Bild in einer Vorhersagephase auf der Grundlage der Probenherstellungsinformationen (41) der Verbundwerkstoffprobe vorherzusagen, wobei die Probenherstellungsinformationen mindestens eines von einem Probenmaterial und einer Formbedingung enthalten, nachdem sie in einer Lernphase einem Lernen unterzogen wurden durch Assoziieren der Probenherstellungsinformationen (41) von Proben mit Talbot-Bildern; und
    einen Rechner (51), der dazu eingerichtet ist, Orientierungsinformationen (43) der Probe auf der Grundlage des vorhergesagten Talbot-Bildes zu berechnen, wobei die Orientierungsinformationen (43) Informationen sind, die eine Faserorientierung der Verbundwerkstoffprobe anzeigen; wobei
    die Lerneinheit (53a) dazu eingerichtet ist, in der Lernphase
    Probenherstellungsinformationen (41) eines Satzes von Proben zu erhalten;
    Talbot-Bilder (42) zu erhalten, die durch Abbilden der Proben mit einer Röntgen-Talbot-Abbildungsvorrichtung (1) erhalten werden; und
    durch Assoziieren der Probenherstellungsinformationen (41) der Proben mit den Talbot-Bildern (42) zu lernen, so dass die Lerneinheit (53a) mit dem Ersatzmodell ein Talbot-Bild in der Vorhersagephase basierend auf den Probenherstellungsinformationen (41) der Probe vorhersagen kann.

2.  Das Informationsverarbeitungsgerät gemäß Anspruch 1, ferner umfassend:
    einen Strukturanalysator (52), der dazu eingerichtet ist, eine Strukturanalyse der Probe auf der Grundlage der berechneten Orientierungsinformation (43) durchzuführen; und
    einen Ausgang (28), der dazu eingerichtet ist, ein Ergebnis der Strukturanalyse auszugeben.

3.  Ein Informationsverarbeitungsgerät umfassend:

    einen Eingang (24, 25), der dazu eingerichtet ist, Probenherstellungsinformationen (41) einer Verbundwerkstoffprobe einzugeben;
    **gekennzeichnet durch**
    eine Lerneinheit (53a, 53b), die ein Surrogatmodell umfasst und dazu eingerichtet ist, in einer Vorhersagephase Orientierungsinformationen (43) der Probe auf der Grundlage von Herstellungsinformationen (41) der Probe vorherzusagen, nachdem die Lerneinheit (53a, 53b) in einer Lernphase ein Lernen durchlaufen hat durch Assoziieren der Probenherstellungsinformationen (41) von Verbundwerkstoffproben, wobei die Probenherstellungsinformationen mindestens eines von einem Probenmaterial und einer Formbedingung enthalten, mit einem Satz von Orientierungsinformationen (43), die auf der Grundlage von Talbot-Bildern erhalten werden, wobei Orientierungsinformationen (43) Informationen sind, die eine Faserorientierung der Verbundwerkstoffprobe angeben; und
    die Lerneinheit (53b) ist dazu eingerichtet:

    die Probenherstellungsinformationen (41) eines Satzes von Proben zu erhalten;
    Talbot-Bilder (42) zu erhalten, die durch Abbilden der Proben mit einer Röntgen-Talbot-Abbildungsvorrichtung (1) erhalten werden;

auf der Grundlage der Talbot-Bilder (42) unter Verwendung eines Rechners (51) Orientierungsinformationen (43) zu erhalten; und

durch Assoziieren der Probenherstellungsinformationen (41) der Proben mit den Orientierungsinformationen (43) zu lernen, so dass die Lerneinheit (53b) mit dem Ersatzmodell eine Orientierungsinformation (43) in der Vorhersagephase basierend auf den Probenherstellungsinformationen (41) der Probe vorhersagen kann.

4. Das Informationsverarbeitungsgerät gemäß Anspruch 3, ferner umfassend:

einen Strukturanalysator (52), der dazu eingerichtet ist, eine Strukturanalyse der Probe auf der Grundlage der vorhergesagten Orientierungsinformation (43) durchzuführen; und

einen Ausgang (28), der dazu eingerichtet ist, ein Ergebnis der Strukturanalyse durch den Strukturanalysator (52) auszugeben.

5. Das Informationsverarbeitungsgerät gemäß Anspruch 1, umfassend:

einen Strukturanalysator (52), der dazu eingerichtet ist, eine Strukturanalyse einer Probe auf der Grundlage von Orientierungsinformationen (43) durchzuführen, die auf der Grundlage des Talbot-Bildes der Probe erhalten wurden; und

einen Ausgang (28), der dazu eingerichtet ist, ein Ergebnis der Strukturanalyse durch den Strukturanalysator (52) auszugeben.

6. Ein Informationsverarbeitungssystem umfassend:

das Informationsverarbeitungsgerät gemäß Anspruch 5, das den Strukturanalysator (52) und den Ausgang (28) enthält,

und eine Anzeige (26); und

eine Röntgen-Talbot-Abbildungsvorrichtung (1), wobei

das Informationsverarbeitungsgerät dazu eingerichtet ist:

ein Talbot-Bilde durch Abbilden einer Probe mit der Röntgen-Talbot-Abbildungsvorrichtung zu erhalten;

Orientierungsinformationen der Probe auf der Grundlage des Talbot-Bildes zu erhalten;

mit dem Strukturanalysator (52) eine Strukturanalyse der Probe basierend auf der Orientierungsinformation der Probe durchzuführen;

mit dem Ausgang (28) ein Ergebnis der Strukturanalyse auszugeben; und

mit der Anzeige (26) das Talbot-Bild, die Orientierungsinformationen, ein Strukturanalysemodell (64), das in der Strukturanalyse verwendet wird, und das Ergebnis der Strukturanalyse anzuzeigen.

7. Ein Informationsverarbeitungsverfahren eines Informationsverarbeitungsgeräts, das Informationsverarbeitungsverfahren umfassend:

Vorhersage von Orientierungsinformationen (43) einer Verbundwerkstoffprobe durch eine Lerneinheit (53a, 53b) mit einem Ersatzmodell in einer Vorhersagephase, nachdem sie in einer Lernphase einem Lernen unterzogen wurde durch Assoziieren von Probenherstellungsinformationen (41) von Verbundwerkstoffproben, wobei die Probenherstellungsinformationen (41) mindestens eines von einem Probenmaterial und einer Formbedingung enthalten, mit einem Satz von Orientierungsinformationen, die auf der Grundlage von Talbot-Bildern der Proben erhalten werden, wobei Orientierungsinformationen (43) Informationen sind, die eine Faserorientierung in der Verbundwerkstoffprobe anzeigen;

Durchführen einer Strukturanalyse der Probe auf der Grundlage der vorhergesagten Orientierungsinformationen; und

Ausgeben eines Ergebnisses der Strukturanalyse.

8. Ein von einem Computer ausführbares Programm, wobei das Programm den Computer veranlasst, das Informationsverarbeitungsverfahren gemäß dem vorhergehenden Anspruch durchzuführen.

9. Ein nicht-flüchtiges Speichermedium, das das Programm gemäß dem vorhergehenden Anspruch speichert.

**Revendications**

1. Appareil de traitement d'information comprenant :

une entrée (24, 25) configurée pour entrer des informations de fabrication d'échantillon (41) d'un échantillon de matériau composite ;
**caractérisé par**
une unité d'apprentissage (53a, 53b) comprenant un modèle de substitution et configurée pour prédire une image Talbot dans une phase de prédiction sur la base des informations de fabrication d'échantillon (41) de l'échantillon de matériau composite, les informations de fabrication d'échantillon comprenant au moins un d'un matériau d'échantillon et d'une condition de moulage, après avoir subi un apprentissage dans une phase d'apprentissage en associant les informations de fabrication d'échantillon (41) d'échantillons, avec des images Talbot ; et
un calculateur (51) configuré pour calculer des informations d'orientation (43) de l'échantillon sur la base de l'image Talbot prédite, dans lequel les informations d'orientation (43) sont des informations qui indiquent une orientation de fibre de l'échantillon de matériau composite ; dans lequel
l'unité d'apprentissage (53a) est configurée pour dans la phase d'apprentissage
obtenir des informations de fabrication d'échantillon (41) d'un ensemble d'échantillons ;
obtenir des images Talbot (42) obtenues par imagerie des échantillons avec un appareil d'imagerie Talbot à rayons X (1) ;
et
apprendre en associant les informations de fabrication d'échantillon (41) des échantillons avec les images Talbot (42) de sorte que l'unité d'apprentissage (53a) avec le modèle de substitution peut prédire une image Talbot dans la phase de prédiction sur la base des informations de fabrication d'échantillon (41) de l'échantillon.

2. L'appareil de traitement d'information selon la revendication 1 comprenant en outre :

un analyseur de structure (52) configuré pour effectuer de l'analyse structurelle de l'échantillon sur la base des informations d'orientation calculées (43) ; et
une sortie (28) configurée pour sortir un résultat de l'analyse structurelle.

3. Appareil de traitement d'information comprenant :

une entrée (24, 25) configurée pour entrer des informations de fabrication d'échantillon (41) d'un échantillon de matériau composite ;
**caractérisé par**
une unité d'apprentissage (53a, 53b) comprenant un modèle de substitution et configurée pour prédire dans une phase de prédiction des informations d'orientation (43) de l'échantillon sur la base des informations de fabrication (41) de l'échantillon après que l'unité d'apprentissage (53a, 53b) a subi un apprentissage dans une phase d'apprentissage en associant les informations de fabrication d'échantillon (41) d'échantillons de matériau composite, des informations de fabrication d'échantillon inclue au moins un d'un matériau d'échantillon et d'une condition de moulage, avec un ensemble d'informations d'orientation (43) obtenues sur la base d'images Talbot, les informations d'orientation (43) étant des informations qui indiquent une orientation de fibre de l'échantillon de matériau composite ; et
l'unité d'apprentissage (53b) est configurée pour :

obtenir les informations de fabrication d'échantillon (41) d'un ensemble d'échantillons ;
obtenir des images Talbot (42) obtenues par imagerie des échantillons avec un appareil d'imagerie Talbot à rayons X (1) ;
obtenir des informations d'orientation (43) sur la base des images Talbot (42) en utilisant un calculateur (51) ;
et
apprendre en associant les informations de fabrication d'échantillon (41) des échantillons avec les informations d'orientation (43) de sorte que l'unité d'apprentissage (53b) avec le modèle de substitution peut prédire une information d'orientation (43) dans la phase de prédiction sur la base des informations de fabrication d'échantillon (41) de l'échantillon.

4. L'appareil de traitement d'information selon la revendication 3 comprenant en outre :

un analyseur de structure (52) configuré pour effectuer de l'analyse structurelle d'un échantillon sur la base des informations d'orientation prédite (43) ; et
une sortie (28) configurée pour sortir un résultat de l'analyse structurelle par l'analyseur de structure (52).

5. L'appareil de traitement d'information selon la revendication 1, comprenant :

un analyseur de structure (52) configuré pour effectuer de l'analyse structurelle d'un échantillon sur la base des informations d'orientation (43) obtenues sur la base de l'image Talbot de l'échantillon ; et
une sortie (28) configurée pour sortir un résultat de l'analyse structurelle par l'analyseur de structure (52).

6. Système de traitement d'information comprenant :

l'appareil de traitement d'information selon la revendication 5, incluant l'analyseur de structure (52) et la sortie (28),
et un écran (26) ; et
un appareil d'imagerie Talbot à rayons X (1), dans lequel
l'appareil de traitement d'information est configuré pour :

obtenir une image Talbot par imagerie d'un échantillon avec l'appareil d'imagerie Talbot à rayons X ;
obtenir des informations d'orientation de l'échantillon sur la base de l'image Talbot ;
effectuer, avec l'analyseur de structure (52), de l'analyse structurelle de l'échantillon sur la base des informations d'orientation de l'échantillon ;
sortir, avec la sortie (28), un résultat de l'analyse structurelle ; et
afficher, avec l'écran (26), l'image Talbot, les informations d'orientation, un modèle d'analyse structurelle (64) utilisé dans l'analyse structurelle, et le résultat de l'analyse structurelle.

7. Méthode de traitement d'information d'un appareil de traitement d'information, la méthode de traitement d'information comprenant :

prédire, par une unité d'apprentissage (53a, 53b) avec un modèle de substitution dans une phase de prédiction, des informations d'orientation (43) d'un échantillon de matériau composite après avoir subi un apprentissage dans une phase d'apprentissage en associant des informations de fabrication d'échantillon (41) d'échantillons de matériau composite, les informations de fabrication d'échantillon (41) incluant au moins un d'un matériau d'échantillon et d'une condition de moulage, avec un ensemble d'informations d'orientation obtenues sur la base d'images Talbot des échantillons, dans lequel les informations d'orientation (43) sont des informations qui indiquent une orientation de fibre de l'échantillon de matériau composite ;
effectuer de l'analyse structurelle de l'échantillon sur la base des informations d'orientation prédite ; et
sortir un résultat de l'analyse structurelle.

8. Programme exécutable par un ordinateur, le programme amenant l'ordinateur à exécuter la méthode de traitement d'information selon la revendication précédente.

9. Support de stockage non transitoire stockant le programme selon la revendication précédente.

# FIG. 1

# FIG. 2

START

Flow analysis — A1

Hold pressure and cooling analysis — A2

Fiber orientation analysis — A3

Structural analysis — A4

END

# FIG. 3

START

Obtain Talbot image — B1

Calculate Talbot orientation information — B2

Structural analysis — A4

END

# FIG. 4

61-2

61-1

61

# FIG. 5

62

# FIG. 6

63

63a

# FIG. 7

64

64a

# FIG. 8

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 4574880 B
- EP 3608659 A1

- US 20190317027 A1

**Non-patent literature cited in the description**

- Directional x-ray dark-field imaging of strongly ordered systems. *PHYSICAL REVIEW B*, 2010, vol. 82, 214103